# EUROPEAN PATENT APPLICATION

(11) **EP 4 510 810 A1**
(43) Date of publication of application: **19.02.2025**
(21) Application number: 23788148.7
(22) Date of filing: 24.03.2023
(51) Int. Cl.: H10K 30/40, H10K 30/50, H10K 71/12, H10K 85/50

(54) **COMPOSITION, AND METHOD FOR PRODUCING PHOTOELECTRIC CONVERSION LAYER**

(30) Priority: 15.04.2022 JP 2022067711
(71) Applicant: Panasonic Intellectual Property Management Co., Ltd., Kadoma-shi, Osaka 571-0057 (JP)
(72) Inventor: OKUMURA Hiroko, Kadoma-shi, Osaka 571-0057 (JP)
(74) Representative: Grünecker Patent- und Rechtsanwälte PartG mbB
(86) International application number: PCT/JP2023/011900
(87) International publication number: WO 2023/199728

(57) **Abstract**

A composition according to the present disclosure includes a perovskite compound precursor, a first solvent, and a second solution. The first solvent has a boiling point of 50°C or more and a dipole moment of 3.0 D or less, and does not dissolve a perovskite compound formed from the perovskite compound precursor. The second solvent has a dipole moment of more than 3.0 D, and dissolves the perovskite compound.

## Description

### TECHNICAL FIELD

The present disclosure relates to a composition and a method for producing a photoelectric conversion film using the same.

### BACKGROUND ART

Non Patent Literature 1 discloses a film-forming technique in which a poor solvent diethyl ether is added to a perovskite precursor solution.

### CITATION LIST

### Non Patent Literature

Non Patent Literature 1: Chongyang Xu and two others, J. Mater. Chem. C, 2020, 8, 15860-15867.

### SUMMARY OF INVENTION

### Technical Problem

The present disclosure aims to provide a composition suitable for forming a perovskite compound-containing film with characteristics comparable to those of conventional perovskite compound-containing films in a simpler manner than conventionally.

### Solution to Problem

A composition of the present disclosure includes a perovskite compound precursor, a first solvent, and a second solution, wherein
the first solvent has a boiling point of 50°C or more and a dipole moment of 3.0 D or less, and does not dissolve a perovskite compound formed from the perovskite compound precursor, and
the second solvent has a dipole moment of more than 3.0 D, and dissolves the perovskite compound.

### Advantageous Effects of Invention

The present disclosure provides a composition suitable for forming a perovskite compound-containing film with characteristics comparable to those of conventional perovskite compound-containing films in a simpler manner than conventionally.

### BRIEF DESCRIPTION OF DRAWINGS

FIG. 1 is a cross-sectional view schematically showing the configuration of a photoelectric conversion element 100.
FIG. 2 is a graph showing the IV curves of photoelectric conversion elements of Examples 1 to 6.
FIG. 3 is a graph showing the IV curves of photoelectric conversion elements of Reference Examples 1 to 6.
FIG. 4 is a graph showing the IV curves of photoelectric conversion elements of Reference Examples 7 and 8.

### DESCRIPTION OF EMBODIMENTS

### (Outline of one aspect according to the present disclosure)

A composition according to a first aspect of the present disclosure includes a perovskite compound precursor, a first solvent, and a second solvent, wherein
the first solvent has a boiling point of 50°C or more and a dipole moment of 3.0 D or less, and does not dissolve a perovskite compound formed from the perovskite compound precursor, and
the second solvent has a dipole moment of more than 3.0 D, and dissolves the perovskite compound.

The composition according to the first aspect is suitable for forming a perovskite compound-containing film with characteristics comparable to those of conventional perovskite compound-containing films in a simpler manner than conventionally.

In a second aspect of the present disclosure, for example, the composition according to the first aspect may be such that the first solvent has a dipole moment of 1.78 D or less.

The composition according to the second aspect is further suitable for forming a perovskite compound-containing film with characteristics comparable to those of conventional perovskite compound-containing films in a simpler manner than conventionally.

In a third aspect of the present disclosure, for example, the composition according to the first or second aspect may be such that the first solvent has a boiling point of 100°C or more.

The composition according to the third aspect is further suitable for forming a perovskite compound-containing film with characteristics comparable to those of conventional perovskite compound-containing films in a simpler manner than conventionally.

In a fourth aspect of the present disclosure, for example, the composition according to any one of the first to third aspects may be such that the first solvent includes a compound having a benzene ring.

The composition according to the fourth aspect is further suitable for forming a perovskite compound-containing film with characteristics comparable to those of conventional perovskite compound-containing films in a simpler manner than conventionally.

In a fifth aspect of the present disclosure, for example, the composition according to the first or second aspect may be such that the first solvent includes at least one selected from the group consisting of tetrahydrofuran, dipropyl ether, diisopropyl ether, toluene, chlorobenzene, methoxybenzene, and methoxytoluene.

The composition according to the fifth aspect is further suitable for forming a perovskite compound-containing film with characteristics comparable to those of conventional perovskite compound-containing films in a simpler manner than conventionally.

In a sixth aspect of the present disclosure, for example, the composition according to any one of the first to fifth aspects may be such that the perovskite compound precursor includes a monovalent cation, a divalent cation, and a monovalent anion.

The composition according to the sixth aspect is further suitable for forming a perovskite compound-containing film with characteristics comparable to those of conventional perovskite compound-containing films in a simpler manner than conventionally.

In a seventh aspect of the present disclosure, for example, the composition according to the sixth aspect may be such that the monovalent cation includes an inorganic cation.

The composition according to the seventh aspect is further suitable for forming a perovskite compound-containing film with characteristics comparable to those of conventional perovskite compound-containing films in a simpler manner than conventionally.

In an eighth aspect of the present disclosure, for example, the composition according to the sixth or seventh aspect may be such that the divalent cation includes at least one selected from the group consisting of Pb and Sn.

The composition according to the eighth aspect is further suitable for forming a perovskite compound-containing film with characteristics comparable to those of conventional perovskite compound-containing films in a simpler manner than conventionally.

In a ninth aspect of the present disclosure, for example, the composition according to any one of the first to eighth aspects may be such that the second solvent includes at least one selected from the group consisting of dimethyl sulfoxide, N,N-dimethylformamide, gamma-butyrolactone, and N-methyl-2-pyrrolidone.

The composition according to the ninth aspect is further suitable for forming a perovskite compound-containing film with characteristics comparable to those of conventional perovskite compound-containing films in a simpler manner than conventionally.

In a tenth aspect of the present disclosure, for example, the composition according to any one of the first to ninth aspects may be such that a volume ratio of the second solvent to a sum of the first solvent and the second solvent is 80% or more and 97% or less.

The composition according to the tenth aspect is further suitable for forming a perovskite compound-containing film with characteristics comparable to those of conventional perovskite compound-containing films in a simpler manner than conventionally.

In an eleventh aspect of the present disclosure, for example, the composition according to the tenth aspect may be such that the volume ratio is 85% or more and 93% or less.

The composition according to the eleventh aspect is further suitable for forming a perovskite compound-containing film with characteristics comparable to those of conventional perovskite compound-containing films in a simpler manner than conventionally.

In a twelfth aspect of the present disclosure, for example, the composition according to any one of the first to eleventh aspects may further include an ammonium salt.

The composition according to the twelfth aspect is suitable for forming a perovskite compound-containing film that can achieve improved characteristics, for example, an improved photoelectric conversion efficiency, compared to those of conventional perovskite compound-containing films in a simpler manner than conventionally.

In a thirteenth aspect of the present disclosure, for example, the composition according to the twelfth aspect may be such that the ammonium salt includes a quaternary ammonium salt.

The composition according to the thirteenth aspect is further suitable for forming a perovskite compound-containing film that can achieve improved characteristics, for example, an improved photoelectric conversion efficiency, compared to those of conventional perovskite compound-containing films in a simpler manner than conventionally.

In a fourteenth aspect of the present disclosure, for example, the composition according to the twelfth or thirteenth aspect may be such that the ammonium salt includes at least one selected from the group consisting of tetrabutylammonium iodide and tetrabutylammonium fluoride.

The composition according to the fourteenth aspect is further suitable for forming a perovskite compound-containing film that can achieve improved characteristics, for example, an improved photoelectric conversion efficiency, compared to those of conventional perovskite compound-containing films in a simpler manner than conventionally.

In a fifteenth aspect of the present disclosure, for example, the composition according to any one of the first to fourteenth aspects may further include a compound including: the same element as a divalent cation included in the perovskite compound precursor; and F.

The composition according to the fifteenth aspect is further suitable for forming a perovskite compound-containing film with characteristics comparable to those of conventional perovskite compound-containing films in a simpler manner than conventionally.

A method for producing a photoelectric conversion layer according to a sixteenth aspect of the present disclosure includes forming a photoelectric conversion layer by using the composition according to any one of the first to fifteenth aspects.

The production method according to the sixteenth aspect can form a perovskite compound-containing film with characteristics comparable to those of conventional perovskite compound-containing films in a simpler manner than conventionally.

In a seventeenth aspect of the present disclosure, for example, the method according to the sixteenth aspect may be such that the photoelectric conversion layer is formed by spin-coating the composition.

The production method according to the seventeenth aspect can form a perovskite compound-containing film with characteristics comparable to those of conventional perovskite compound-containing films in a simpler manner than conventionally.

Embodiments of the present disclosure are described below with reference to the drawings. The present disclosure is not limited to the following embodiments.

### (First embodiment)

A composition of a first embodiment includes a perovskite compound precursor, a first solvent, and a second solvent. The first solvent has a boiling point of 50°C or more and a dipole moment of 3.0 D or less, and does not dissolve a perovskite compound formed from the above perovskite compound precursor. The second solvent has a dipole moment of more than 3.0 D, and dissolves the above perovskite compound.

With the composition of the first embodiment configured as above, it is possible to form a perovskite compound-containing film with characteristics comparable to those of conventional perovskite compound-containing films in a simpler manner than conventionally. In one example, the composition of the first embodiment can achieve a photoelectric conversion efficiency comparable to those of conventional perovskite compound-containing films. With the composition of the first embodiment, it is also possible, for example, to form a homogeneous perovskite compound-containing film in a simple and highly reproducible manner. In other words, using the composition of the first embodiment to form a perovskite film can reduce variations within the film.

A conventional known technique for forming a perovskite compound-containing film involves spin coating of a precursor solution of a perovskite compound onto a substrate on which a perovskite compound-containing film is to be formed, during which a poor solvent is added dropwise to the substrate. In this technique, achieving good reproducibility is particularly difficult when the distance from the substrate to which the poor solvent is to be added dropwise and the flow rate of the poor solvent to be added dropwise are not fully automated. This has led to issues such as formation of nonhomogeneous films and a failure to achieve homogeneous films with high reproducibility.

The above conventional technique, which involves spin coating onto a substrate on which a perovskite compound-containing film is to be formed during which a poor solvent is added dropwise to the substrate, has also had an issue of a large amount of the poor solvent used. This issue has been a contributing factor to increased production costs, for example, in forming a large-area perovskite compound-containing film. In contrast, when the composition of the first embodiment is used to form a perovskite compound-containing film, there is no need for conventional dropwise addition of a poor solvent, thereby also achieving a significant reduction in the amount of poor solvent used.

Non Patent Literature 1 discloses a film-forming technique in which a poor solvent diethyl ether is added to a precursor solution of a perovskite compound MAPbl₃. "MA" represents "CH₃NH₃". Due to diethyl ether, which has a low boiling point, being used as the poor solvent, the technique has an issue of the poor solvent evaporating even at room temperature during spin coating or during preparation of the precursor solution.

By using the composition of the first embodiment as a precursor of a perovskite film, it is possible to form a homogeneous perovskite film with high reproducibility, without employing a complicated technique involving a precise dropwise addition of a poor solvent.

The components are described below.

### (First solvent)

The first solvent has a boiling point of 50°C or more and a dipole moment of 3.0 D or less. The first solvent is a solvent that does not dissolve a perovskite compound. As used herein, a solvent that does not dissolve a perovskite compound refers to a solvent in which the dissolution concentration of the perovskite compound does not exceed 0.01 mol/L.

To improve reproducibility, the first solvent may have a dipole moment of 1.78 D or less.

The first solvent may have a boiling point of 100°C or more.

The first solvent may include a compound having a benzene ring.

The first solvent may include at least one selected from the group consisting of tetrahydrofuran, dipropyl ether, diisopropyl ether, toluene, chlorobenzene, methoxybenzene, and methoxytoluene.

Tetrahydrofuran, dipropyl ether, diisopropyl ether, toluene, chlorobenzene, methoxybenzene, and 4-methoxytoluene have the following boiling points and dipole moments.
· Tetrahydrofuran: boiling point 66°C, dipole moment 1.75 D
· Dipropyl ether: boiling point 90°C, dipole moment 1.15 D
· Diisopropyl ether: boiling point 68°C, dipole moment 1.22 D
· Toluene: boiling point 110.6°C, dipole moment 0.36 D
· Chlorobenzene: boiling point 132°C, dipole moment 1.54 D
· Methoxybenzene: boiling point 153.8°C, dipole moment 1.38 D
· 4-Methoxytoluene: boiling point 175°C, dipole moment 1.20 D

### (Perovskite compound precursor)

The perovskite compound precursor may include a monovalent cation, a divalent cation, and a monovalent anion.

Examples of the monovalent cation include an organic cation and an inorganic cation. The monovalent cation may include an inorganic cation. The monovalent cation may be an inorganic cation.

Examples of the organic cation include a methylammonium cation (CH₃NH₃⁺) and a formamidinium cation (NH₂CHNH₂⁺).

Examples of the inorganic cation include a Cs cation and a Rb cation.

Examples of the divalent cation include a Pb cation and a Sn cation. In other words, the divalent cation may include at least one selected from the group consisting of a Pb cation and a Sn cation.

### (Second solvent)

The second solvent has a dipole moment of more than 3.0 D.

The second solvent may include at least one selected from the group consisting of dimethyl sulfoxide (DMSO), N,N-dimethylformamide (DMF), gamma-butyrolactone (GBL), and N-methyl-2-pyrrolidone (NMP).

DMSO, DMF, GBL, and NMP have the following boiling points and dipole moments.
· DMSO: boiling point 189°C, dipole moment 3.96 D
· DMF: boiling point 153°C, dipole moment 3.82 D
· GBL: boiling point 204°C, dipole moment 4.12 D
· NMP: boiling point 202°C, dipole moment 4.09 D

The volume ratio of the second solvent to the sum of the first solvent and the second solvent may be 80% or more and 97% or less. The volume ratio may be 85% or more and 93% or less.

### (Other components)

The composition of the first embodiment may further include an ammonium salt.

With the composition of the first embodiment configured as above, it is possible to produce a perovskite compound-containing film with improved characteristics, for example, a perovskite compound-containing film with an improved photoelectric conversion efficiency, compared to those of conventional perovskite compound-containing films. In other words, with the composition of the first embodiment configured as above, it is possible to produce a photoelectric conversion layer with an improved photoelectric conversion efficiency in a simple manner.

To obtain a film with an improved photoelectric conversion efficiency, the ammonium salt may include at least one selected from the group consisting of an alkyl group and an aryl group. The carbon number of the alkyl group may be 1 or more and 10 or less. The carbon number of the alkyl group may be 1 or more and 7 or less.

To obtain a film with an improved photoelectric conversion efficiency, the ammonium salt may include a quaternary ammonium salt. The ammonium salt may be a quaternary ammonium salt.

To obtain a film with an improved photoelectric conversion efficiency, the ammonium salt may include a halogen element. The halogen element is, for example, fluorine, chlorine, bromine, or iodine.

The ammonium salt may include iodine. Such an ammonium salt is, for example, tetrapropylammonium iodide, tetrabutylammonium iodide, tetraamylammonium iodide, tetrahexylammonium iodide, or tetraheptylammonium iodide.

The ammonium salt may include fluorine. Such an ammonium salt is, for example, tetrabutylammonium fluoride.

The above ammonium salt may include at least one selected from the group consisting of tetrabutylammonium iodide (TBAI) and tetrabutylammonium fluoride (TBAF). In other words, the composition of the first embodiment, which includes the perovskite compound precursor and the first solvent, may further include at least one selected from the group consisting of tetrabutylammonium iodide (TBAI) and tetrabutylammonium fluoride (TBAF).

The composition according to the first embodiment may further include a compound including: the same element as a divalent cation included in the perovskite compound precursor; and F. For example, in the case where the perovskite compound precursor included in the composition according to the first embodiment includes a Sn cation as a divalent cation, the composition according to the first embodiment may include SnF₂ as the above compound. In the case where a perovskite compound to be produced includes a Sn cation as a divalent cation, further including SnF₂ in the composition according to the first embodiment can obtain a perovskite compound film with reduced Sn defects.

The composition of the first embodiment can be produced, for example, by the following method.

The composition of the first embodiment is obtained, for example, by mixing the perovskite compound precursor and the first solvent. In addition, the second solvent may be mixed.

Here, a case is described in which the perovskite compound precursor includes a monovalent cation, a divalent cation, and a monovalent anion, and the monovalent anion is a halogen anion.

The perovskite compound precursor includes, for example, a first compound including a monovalent cation and halogen, such as CsI, and a second compound including a divalent cation and halogen, such as SnI₂.

The composition of the first embodiment may further include a compound including a divalent cation and F, such as SnF₂.

The following describes one example of the method for producing the composition according to the first embodiment, with use of an example case where the composition of the first embodiment includes, in addition to the perovskite compound precursor and the first solvent, the second solvent and a compound including a divalent cation and F, such as SnF₂. A first solution is prepared by adding the above first compound, which includes a monovalent cation and halogen, and the above second compound, which includes a divalent cation and halogen, to a solvent mixture of the first solvent and the second solvent. A second solution is prepared by adding a compound including a divalent cation and F, such as SnF₂, to the second solvent. The composition according to the first embodiment is obtained by mixing the first solution and the second solution.

### (Second embodiment)

In a second embodiment, a method for producing a photoelectric conversion layer using the composition according to the first embodiment is described. In the second embodiment, the following describes a photoelectric conversion layer obtained by using the composition of the first embodiment and a photoelectric conversion element including the photoelectric conversion layer. The features specified in the first embodiment may be omitted as appropriate.

A photoelectric conversion layer produced by the production method of the second embodiment is hereinafter referred to as a photoelectric conversion layer of the second embodiment. In addition, a photoelectric conversion element including the photoelectric conversion layer produced by the production method of the second embodiment is hereinafter referred to as a photoelectric conversion element of the second embodiment.

The production method of the second embodiment includes forming a photoelectric conversion layer by using the composition of the first embodiment.

The photoelectric conversion layer of the second embodiment is formed by using the composition of the first embodiment. Consequently, the photoelectric conversion element of the second embodiment including the photoelectric conversion layer of the second embodiment has a high photoelectric conversion efficiency.

In the production method of the second embodiment, the photoelectric conversion layer may be formed by spin-coating the composition of the first embodiment.

The photoelectric conversion element of the second embodiment is not particularly limited. The photoelectric conversion element of the second embodiment includes, for example, a first electrode, a photoelectric conversion layer, and a second electrode that are disposed in this order. The photoelectric conversion element of the second embodiment is, for example, a solar cell, a light-emitting device, or an optical sensor.

The photoelectric conversion element of the second embodiment is, for example, a solar cell. The solar cell is, for example, a perovskite solar cell.

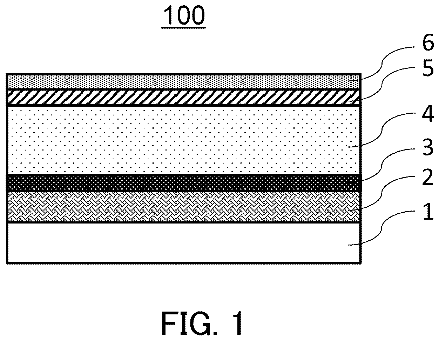

FIG. 1 is a cross-sectional view schematically showing the configuration of a photoelectric conversion element 100 according to the second embodiment.

The photoelectric conversion element 100 according to the second embodiment includes a substrate 1, a first electrode 2, an electron transport layer 3, a photoelectric conversion layer 4, a hole transport layer 5, and a second electrode 6 that are disposed in this order.

The photoelectric conversion layer 4 is formed by using the composition of the first embodiment.

The photoelectric conversion element 100 may omit the substrate 1, the electron transport layer 3, and the hole transport layer 5.

Upon irradiation of the photoelectric conversion element 100 with light, the photoelectric conversion layer 4 absorbs the light and then charge separation into electrons and holes occurs. The electrons resulting from this charge separation transfer to the first electrode 2 through the electron transport layer 3. On the other hand, the holes formed in the photoelectric conversion layer 4 transfer to the second electrode 6 via the hole transport layer 5. The photoelectric conversion element 100 can thereby draw out an electric current from the first electrode 2 functioning as the negative electrode and the second electrode 6 functioning as the positive electrode.

The components of the photoelectric conversion element 100 are specifically described below.

### (Substrate 1)

The substrate 1 plays the role of supporting the layers in the photoelectric conversion element 100.

The substrate 1 can be formed from a transparent material. A glass substrate or a plastic substrate, for example, can be used as the substrate 1. The plastic substrate may be, for example, a plastic film.

When the second electrode 6 has a light-transmitting property, the substrate 1 may be made of a material not having a light-transmitting property. As the material can be used a metal, a ceramic, or a resin material having a low light-transmitting property.

When the first electrode 2 is strong enough to support the layers, the substrate 1 may be omitted.

### (First electrode 2)

The first electrode 2 has electrical conductivity.

The first electrode 2 has a light-transmitting property. For example, the first electrode 2 allows visible to near-infrared light to pass therethrough.

The first electrode 2 is made of, for example, a material being transparent and having electrical conductivity. Examples of the material include a metal oxide and a metal nitride. Examples of the material include the following:
(i) titanium oxide doped with at least one selected from the group consisting of lithium, magnesium, niobium, and fluorine,
(ii) gallium oxide doped with at least one selected from the group consisting of tin and silicon,
(iii) gallium nitride doped with at least one selected from the group consisting of silicon and oxygen,
(iv) tin oxide doped with at least one selected from the group consisting of antimony and fluorine,
(v) zinc oxide doped with at least one selected from the group consisting of boron, aluminum, gallium, and indium,
(vi) indium-tin composite oxide, and
(vii) a composite thereof.

The first electrode 2 may be formed to have a pattern that allows light to pass therethrough. Examples of the pattern that allows light to pass through include a linear pattern, a wave line pattern, a lattice pattern, and a perforated-metal-like pattern where numerous fine through holes are regularly or irregularly arranged. When the first electrode 2 has any of these patterns, light can pass through portions without the electrode material. Thus, the first electrode 2 having the pattern that allows light to pass therethrough can include a non-transparent material. Examples of the non-transparent electrode material include platinum, gold, silver, copper, aluminum, rhodium, indium, titanium, iron, nickel, tin, zinc, and an alloy including any of these. An electrically conductive carbon material may be used as the non-transparent electrode material.

The light-transmitting property of the first electrode 2 is not necessarily achieved by the above-described pattern that allows light to pass therethrough. For example, the first electrode 2 may be formed as a thin metal film having a thickness of approximately 10 nm. The thin metal film is made of, for example, platinum, gold, silver, copper, aluminum, rhodium, indium, titanium, iron, nickel, tin, zinc, or an alloy including any of these. An electrically conductive carbon material may be used in place of these metal materials.

In the case where the photoelectric conversion element 100 does not include the electron transport layer 3, the first electrode 2 has a property of blocking holes from the photoelectric conversion layer 4. In this case, the first electrode 2 is not in ohmic contact with the photoelectric conversion layer 4. The property of blocking holes from the photoelectric conversion layer 4 refers to a property of allowing only electrons formed in the photoelectric conversion layer 4 to pass through and not allowing holes to pass through. The Fermi energy of a material having such a property is higher than the energy at the top of the valence band of the photoelectric conversion layer 4. The Fermi energy of a material having such a property may be higher than the Fermi energy of the photoelectric conversion layer 4. The material is specifically aluminum.

In the case where the photoelectric conversion element 100 includes the electron transport layer 3, the first electrode 2 does not necessarily have the property of blocking holes from the photoelectric conversion layer 4. In this case, the first electrode 2 can include a material capable of forming an ohmic contact with the photoelectric conversion layer 4. In this case, the first electrode 2 may be in ohmic contact with the photoelectric conversion layer 4, or is not necessarily in ohmic contact with the photoelectric conversion layer 4.

The transmittance of the first electrode 2 may be, for example, 50% or more, or 80% or more. The wavelength of light that is to pass through the first electrode 2 depends on the absorption wavelength of the photoelectric conversion layer 4.

The thickness of the first electrode 2 may be, for example, 1 nm or more and 1000 nm or less.

### (Electron transport layer 3)

The electron transport layer 3 includes an electron transport material. The electron transport material is a material that transports electrons. The electron transport material can be a semiconductor. The electron transport layer 3 may be made of a semiconductor having a band gap of 3.0 eV or more. In this case, visible light and infrared light are allowed to pass through to the photoelectric conversion layer 4.

The electron transport material is, for example, an inorganic n-type semiconductor.

Examples of the inorganic n-type semiconductor include a metal oxide, a metal nitride, and a perovskite oxide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂ or SnO₂. The metal nitride is, for example, GaN. The perovskite oxide is, for example, SrTiO₃ or CaTiO₃.

The electron transport layer 3 may include a semiconductor having a band gap of 6.0 eV or more to effectively allow ultraviolet to pass therethrough to the photoelectric conversion layer 4. Examples of the semiconductor include halides, such as lithium fluoride and calcium fluoride, of alkali metals and alkaline earth metals, alkali metal oxides such as magnesium oxide, and silicon dioxide. In this case, the electron transport layer 3 may have a thickness of, for example, 10 nm or less to secure the electron transport capability of the electron transport layer 3.

The electron transport layer 3 may include a plurality of layers made of different materials.

### (Photoelectric conversion layer 4)

The photoelectric conversion layer 4 includes a photoelectric conversion material. The photoelectric conversion layer 4 is formed by using the composition of the first embodiment. The perovskite compound is represented, for example, by the composition formula ABX₃, wherein A is a monovalent cation, B is a divalent metal cation, and X is a monovalent anion.

The monovalent cation A is, for example, an organic cation or an alkali metal cation.

Examples of the organic cation include a methylammonium cation (CH₃NH₃⁺) and a formamidinium cation (NH₂CHNH₂⁺).

Examples of the alkali metal cation include a Cs cation and a Rb cation.

Examples of the divalent cation B include a Pb cation and a Sn cation.

Examples of the monovalent anion X include a halogen anion. The halogen anion is, for example, chlorine, bromine, or iodine.

A, B, and X may each include more than one type of ion.

The photoelectric conversion layer 4 has a thickness of, for example, 50 nm or more and 10 µm or less.

### (Hole transport layer 5)

The hole transport layer 5 includes a hole transport material. The hole transport material is a material that transports holes. The hole transport material is, for example, an organic semiconductor or an inorganic semiconductor.

Examples of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (which may be referred to as "PTAA" hereinafter), poly(3-hexylthiophene-2,5-diyl), poly(3,4-ethylenedioxythiophene), and copper phthalocyanine.

The inorganic semiconductor used as the hole transport material is a p-type semiconductor. Examples of the inorganic semiconductor include Cu₂O, CuGaO₂, CuSCN, Cul, NiOₓ, MoOₓ, V₂O₅, and a carbon material such as graphene oxide, wherein x satisfies x > 0.

The hole transport layer 5 may include a plurality of layers made of different materials. For example, the hole transport properties of the hole transport layer 5 are improved by stacking the plurality of layers whose ionization potentials are smaller than that of the photoelectric conversion layer 4 such that the ionization potentials decrease layer by layer.

The hole transport layer 5 may have a thickness of 1 nm or more and 1000 nm or less, or 10 nm or more and 50 nm or less. This allows the hole transport layer 5 to exhibit sufficiently high hole transport properties. Consequently, the resistance of the photoelectric conversion element can be maintained at a low level, and a high photoelectric conversion efficiency can be achieved.

The hole transport layer 5 is formed, for example, by a coating technique, a printing technique, or a deposition technique. The same applies to the photoelectric conversion layer 4. Examples of the coating technique include doctor blade coating, bar coating, spraying, dip coating, inkjet coating, slit coating (namely, die coating), and spin coating. Examples of the printing technique include screen printing. If needed, the hole transport layer 5 may be formed using a mixture of a plurality of materials and then, for example, compressed or baked. In the case where the material of the hole transport layer 5 is a low-molecular-weight organic substance or an inorganic semiconductor, the hole transport layer 5 can be produced by vacuum deposition.

The hole transport layer 5 may include not only the hole transport material but also an additive to increase the electrical conductivity. Examples of the additive include a supporting electrolyte, a solvent, and a dopant. The supporting electrolyte and the solvent stabilize holes in the hole transport layer 5. The dopant increases the number of holes in the hole transport layer 5.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium tetrafluoroborate. Examples of the alkaline earth metal salt include lithium bis(trifluoromethanesulfonyl)imide and calcium(II) bis(trifluoromethanesulfonyl)imide. Examples of the transition metal salt include zinc(II) bis(trifluoromethanesulfonyl)imide and tris[4-tert-butyl-2-(1H-pyrazole-1-yl)pyridine]cobalt(III) tris(trifluoromethanesulfonyl)imide.

Examples of the dopant include a fluorine-containing aromatic boron compound. Examples of the fluorine-containing aromatic boron compound include tris(pentafluorophenyl)borane.

The solvent included in the hole transport layer 5 may have excellent ion conductivity. The solvent may be an aqueous solvent or an organic solvent. To make the solute more stable, the solvent included in the hole transport layer 5 may be an organic solvent. Examples of the organic solvent include heterocyclic compound solvents such as tert-butylpyridine, pyridine, and n-methylpyrrolidone.

An ionic liquid may be used as the solvent. The ionic liquid may be used alone, or may be used after mixed with a different solvent. The ionic liquid is desirable for its low volatility and high flame retardancy.

Examples of the ionic liquid include imidazolium ionic liquids such as 1-ethyl-3-methylimidazolium tetracyano borate, pyridine ionic liquids, alicyclic amine ionic liquids, aliphatic amine ionic liquids, and azonium amine ionic liquids.

### (Second electrode 6)

The second electrode 6 has electrical conductivity.

In the case where the photoelectric conversion element 100 does not include the hole transport layer 5, the second electrode 6 has a property of blocking electrons from the photoelectric conversion layer 4. In this case, the second electrode 6 is not in ohmic contact with the photoelectric conversion layer 4. The property of blocking electrons from the photoelectric conversion layer 4 refers to a property of allowing only holes formed in the photoelectric conversion layer 4 to pass through and not allowing electrons to pass through. The Fermi energy of a material having such a property is lower than the energy at the bottom of the conduction band of the photoelectric conversion layer 4. The Fermi energy of a material having such a property may be lower than the Fermi energy of the photoelectric conversion layer 4. The material is specifically platinum, gold, or a carbon material such as graphene.

In the case where the photoelectric conversion element 100 includes the hole transport layer 5, the second electrode 6 does not necessarily have the property of blocking electrons from the photoelectric conversion layer 4. In this case, the second electrode 6 can include a material capable of forming an ohmic contact with the photoelectric conversion layer 4. Therefore, the second electrode 6 can be formed to have a light-transmitting property.

An electrode that is the first electrode 2 or the second electrode 6 and that is configured to allow light to be incident thereon needs to have a light-transmitting property. That is, either the first electrode 2 or the second electrode 6 does not necessarily have a light-transmitting property. That is, either the first electrode 2 or the second electrode 6 does not necessarily include a material having a light-transmitting property, or does not necessarily have a pattern with openings that allow light to pass therethrough.

### (Porous layer)

A porous layer is formed on the electron transport layer 3, for example, by a coating technique. In the case where the photoelectric conversion element 100 does not include the electron transport layer 3, the porous layer is formed on the first electrode 2.

The pore structure provided by the porous layer serves as the foundation for forming the photoelectric conversion layer 4. The porous layer does not prevent either light absorption by the photoelectric conversion layer 4 or electron transfer from the photoelectric conversion layer 4 to the electron transport layer 3.

The porous layer includes a porous body.

The porous body is made of, for example, continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide, a perovskite oxide of a metal element, a sulfide of a metal element, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂. The perovskite oxide of a metal element is, for example, SrTiO₃ or CaTiO₃. The sulfide of a metal element is, for example, CdS, ZnS, In₂S₃, PbS, Mo₂S, WS₂, Sb₂S₃, Bi₂S₃, ZnCdS₂, or Cu₂S. The metal chalcogenide is, for example, CsSe, In₂Se₃, WSe₂, HgS, PbSe, or CdTe.

The porous layer may have a thickness of 0.01 µm or more and 10 µm or less, or 0.05 µm or more and 1 µm or less.

The surface roughness of the porous layer in terms of a surface roughness factor determined by effective area/projected area may be 10 or more, or 100 or more. The projected area refers to the area of a shadow behind an object irradiated with light from the front. The effective area refers to the actual surface area of an object. The effective area can be calculated from the volume of an object, the specific surface area of the material of the object, and the bulk density of the material of the object, the volume being determined from the projected area and the thickness of the object. The specific surface area is measured, for example, by a nitrogen adsorption method.

The voids in the porous layer are continuous from one principal surface of the porous layer to the other principal surface. That is, the voids in the porous layer are continuous from a principal surface of the porous layer in contact with the photoelectric conversion layer 4 to a principal surface of the porous layer in contact with the electron transport layer 3. This allows the material of the photoelectric conversion layer 4 to fill the voids in the porous layer and reach the surface of the electron transport layer 3. The photoelectric conversion layer 4 and the electron transport layer 3 are thus in direct contact with each other and therefore can transfer electrons therebetween.

Inclusion of the porous layer makes it easy to form the photoelectric conversion layer 4. By including the porous layer, the material of the photoelectric conversion layer 4 enters the voids in the porous layer and the porous layer serves as a foothold for the photoelectric conversion layer 4. This makes it unlikely that the material of the photoelectric conversion layer 4 is repelled by the surface of the porous layer or becomes aggregated on the surface of the porous layer. Consequently, the photoelectric conversion layer 4 can be easily formed as a uniform film. The photoelectric conversion layer 4 can be formed by the coating technique, printing technique, deposition technique described above, or the like.

It is also expected that light scattering caused by the porous layer can increase the optical path length of light passing through the photoelectric conversion layer 4. The increased optical path length is predicted to increase the amount of electrons and holes formed in the photoelectric conversion layer 4.

### Examples

The present disclosure is described in more detail below, with reference to examples.

In the following process, preparation of raw material solutions of photoelectric conversion layers and hole transport layers and formation of these layers were performed in a glove box where the oxygen concentration and the moisture concentration were each 1 ppm or less.

### <Formation of photoelectric conversion element: Examples 1 to 6>

First, a glass substrate was prepared. The substrate plays the role of a supporting material for the photoelectric conversion element of the present disclosure.

On the substrate, an indium tin oxide (ITO) layer and an antimony tin oxide (ATO) layer were formed in this order by sputtering. The first electrode was formed in this manner.

Next, on the ATO layer, a compact titanium oxide (TiO₂) layer was formed by sputtering. This compact titanium oxide layer corresponds, for example, to the electron transport layer described in the second embodiment above.

Next, 0.45 g of a titanium oxide paste 30NR-D (manufactured by Gratcell Solar Materials Pty Ltd.) was dissolved in 2 mL of a butanol solution. The resulting solution was applied to the electron transport layer by spin coating, followed by baking at 500°C for 20 minutes. A porous titanium oxide layer was formed in this manner. The spin coating was performed at 4000 rpm for 20 seconds. It should be noted that both the above compact titanium oxide layer and the above porous titanium oxide layer have an electron transport capability. Therefore, it can be considered that the electron transport layer is composed of the above compact titanium oxide layer and the above porous titanium oxide layer.

A precursor solution of a photoelectric conversion layer was applied to the porous layer by spin coating and then allowed to stand at room temperature for 10 minutes. Next, the resulting coating film was baked at 160°C for 1 minute and then at 220°C for 10 minutes. A photoelectric conversion layer was formed in this manner. The spin coating was performed at 5000 rpm for 30 seconds. During the spin coating, dropwise addition of a poor solvent was not performed.

The precursor solutions of the photoelectric conversion layers of the examples were obtained as follows. The precursor solutions of the photoelectric conversion layers of the examples each correspond to the composition of the first embodiment. The first solution of 1.2 mol/L was first prepared by adding SnI₂ and CsI to a solvent mixture of DMF, DMSO, and the first solvent (volume ratio of DMF:DMSO:first solvent = 2:7:1). The first solvents of Examples 1 to 6 used were respectively tetrahydrofuran, diisopropyl ether, dipropyl ether, chlorobenzene, methoxybenzene, and 4-methoxytoluene.

The second solution of 1.2 mol/L was then prepared by adding SnF₂ to a solvent mixture of DMF and DMSO (volume ratio of DMF:DMSO = 1:4). A third solution of 1.2 mol/L was then prepared by adding TBAI to a solvent mixture of DMF and DMSO (volume ratio of DMF:DMSO = 1:4).

To the first solution, the second solution and the third solution were added. This resulted in the precursor solutions of the photoelectric conversion layers of the examples. The precursor solutions of the present examples each included DMF and DMSO as the second solvent. Moreover, in the present examples, the volume ratio of the second solvent to the sum of the first solvent and the second solvent was 92%.

In the precursor solution of the photoelectric conversion layer, the concentration of the second solution added was 16 mol% and the concentration of the third solution added was 5 mol%. The photoelectric conversion layer was obtained by baking the coating film of the precursor solution at 160°C for 1 minute and then at 220°C for 10 minutes, as described above.

Next, a raw material solution of a hole transport layer was applied to the photoelectric conversion layer by spin coating. A hole transport layer was formed in this manner. The raw material solution of the hole transport layer was prepared by dissolving 18 mg of poly[bis(4-phenyl)(2,4,6-triphenyl)amine] (PTAA) in 1 mL of chlorobenzene. The spin coating was performed at 4000 rpm for 20 seconds.

Next, a gold film was formed on the hole transport layer by deposition. The second electrode having a thickness of 200 nm was formed in this manner.

Finally, a UV-curable epoxy resin was applied to the periphery of the substrate, another glass substrate was placed thereon, and the resulting laminate was subjected to UV irradiation. The epoxy resin was thereby cured to encapsulate the electricity generation constituents.

### <Formation of photoelectric conversion element: Reference Examples 1 to 6>

The process from the preparation of the glass substrate to the formation of the electron transport layer was performed in the same manner as in the examples.

A precursor solution of a photoelectric conversion layer was applied to the porous layer by spin coating and then allowed to stand at room temperature for 10 minutes. Next, the resulting coating film was baked at 160°C for 1 minute and then at 220°C for 10 minutes. A photoelectric conversion layer was formed in this manner. The spin coating was performed at 5000 rpm for 30 seconds. During the spin coating, a solvent having a small dipole moment was added dropwise. The respective solvents each having a small dipole moment used were a solvent with characteristics between those of a poor solvent and a good solvent, tetrahydrofuran, and poor solvents diisopropyl ether, dipropyl ether, methoxybenzene, 4-methoxytoluene, and toluene.

The precursor solutions of the photoelectric conversion layers of Reference Examples 1 to 6 were obtained as follows. The first solution of 1.2 mol/L was first prepared by adding SnI₂ and CsI to a solvent mixture of DMF and DMSO (volume ratio of DMF:DMSO = 1:4). The second solution of 1.2 mol/L was then prepared by adding SnF₂ to a solvent mixture of DMF and DMSO (volume ratio of DMF:DMSO = 1:4). The third solution of 1.2 mol/L was then prepared by adding TBAI to a solvent mixture of DMF and DMSO (volume ratio of DMF:DMSO = 1:4).

To the first solution, the second solution and the third solution were added. This resulted in the precursor solutions of the photoelectric conversion layers of Reference Examples 1 to 6.

In the precursor solution of the photoelectric conversion layer, the concentration of the second solution added was 16 mol% and the concentration of the third solution added was 5 mol%. The photoelectric conversion layer was obtained by baking the coating film of the precursor solution at 160°C for 1 minute and then at 220°C for 10 minutes, as described above.

The subsequent process from the formation of the hole transport layer to the encapsulation was performed in the same manner as in the examples.

### <Formation of photoelectric conversion element: Reference Examples 7 and 8>

The process from the preparation of the glass substrate to the formation of the electron transport layer was performed in the same manner as in the examples.

A precursor solution of a photoelectric conversion layer was applied to the porous layer by spin coating and then allowed to stand at room temperature for 10 minutes. Next, the resulting coating film was baked at 160°C for 1 minute and then at 220°C for 10 minutes. A photoelectric conversion layer was formed in this manner. In Reference Examples 7 and 8, during the spin coating, dropwise addition of a poor solvent was not performed, unlike in Reference Examples 1 to 6.

The precursor solution of the photoelectric conversion layer of Reference Example 7 was obtained as follows. The first solution of 0.9 mol/L was first prepared by adding SnI₂ and CsI to a solvent mixture of DMF and DMSO (volume ratio of DMF:DMSO = 1:4). The second solution of 0.9 mol/L was then prepared by adding SnF₂ to a solvent mixture of DMF and DMSO (volume ratio of DMF:DMSO = 1:4). The third solution of 0.9 mol/L was then prepared by adding TBAI to a solvent mixture of DMF and DMSO (volume ratio of DMF:DMSO = 1:4).

The precursor solution of the photoelectric conversion layer was Reference Example 8 was obtained as follows. The first solution of 1.5 mol/L was first prepared by adding SnI₂ and CsI to a solvent mixture of DMF and DMSO (volume ratio of DMF:DMSO = 1:4). The second solution of 1.5 mol/L was then prepared by adding SnF₂ to a solvent mixture of DMF and DMSO (volume ratio of DMF:DMSO = 1:4). The third solution of 1.5 mol/L was then prepared by adding TBAI to a solvent mixture of DMF and DMSO (volume ratio of DMF:DMSO = 1:4).

In the precursor solution of the photoelectric conversion layer of Reference Examples 7 and 8, the concentration of the second solution added was 16 mol% and the concentration of the third solution added was 5 mol%. The photoelectric conversion layer was obtained by baking the coating film of the precursor solution at 160°C for 1 minute and then at 220°C for 10 minutes, as described above.

### <Characteristic evaluation of photoelectric conversion element>

The current-voltage characteristics (namely, IV characteristics) were evaluated for the photoelectric conversion elements of the examples and the reference examples.

A solar simulator (manufactured by Bunkoukeiki Co., Ltd.) and an electrochemical analyzer ALS (manufactured by BAS Inc.) were used for the characteristic evaluation. Each photoelectric conversion element was irradiated with one sun of simulated sunlight. The output of the solar simulator was set to 100 mW/cm². The IV characteristics of the photoelectric conversion elements were measured by measuring the output current values with the electrochemical analyzer under varying applied voltage.

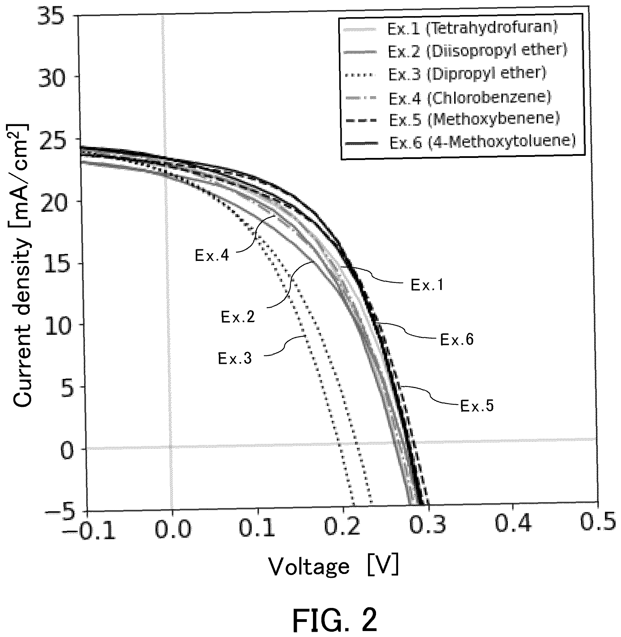

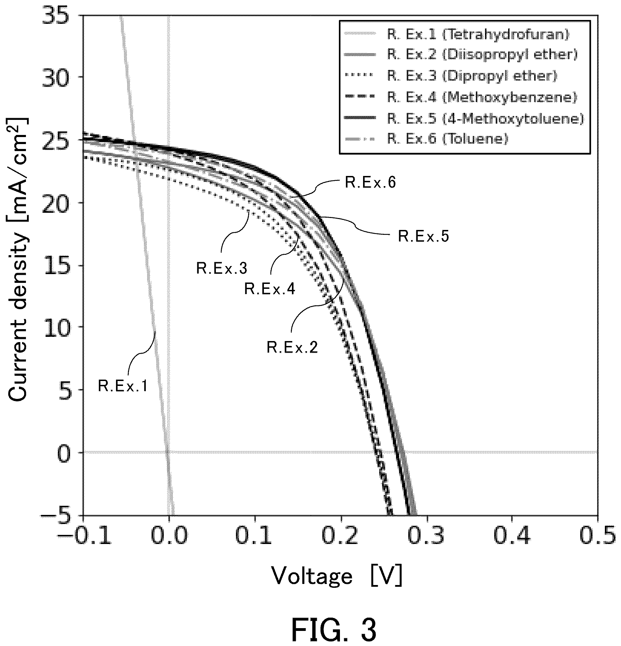

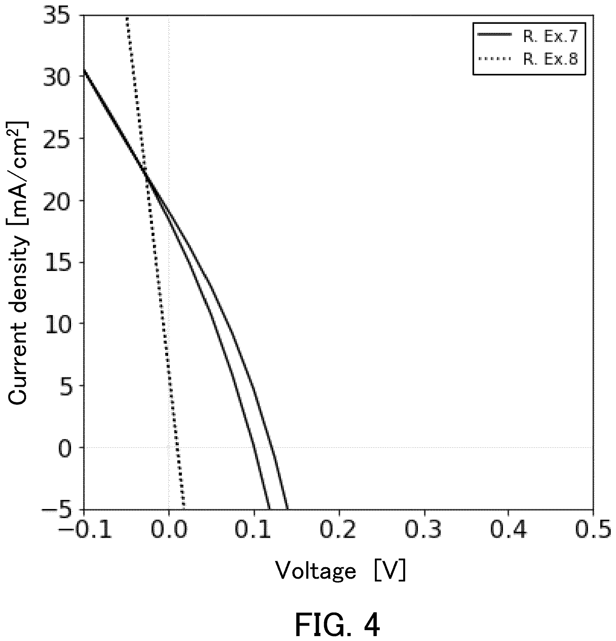

FIG. 2 is a graph showing the IV curves of the photoelectric conversion elements of Examples 1 to 6. FIG. 3 is a graph showing the IV curves of the photoelectric conversion elements of Reference Examples 1 to 6. FIG. 4 is a graph showing the IV curves of the photoelectric conversion elements of Reference Examples 7 and 8.

The measurement results for Examples 1 to 6 are shown in Table 1. The measurement results for Reference Examples 1 to 6 are shown in Table 2. The measurement results of Reference Examples 7 and 8 are shown in Table 3. In the tables, η represents conversion efficiency; J_{SC} represents short-circuit current density; V_{oc} represents open-circuit voltage; and FF represents fill factor.

**[Table 1]**

| | First solvent | η (%) | Jsc (mA/cm²) | Voc (V) | FF (-) |
|---|---|---|---|---|---|
| Example 1 | Tetrahydrofuran | 2.92 | 22.990 | 0.278 | 0.456 |
| Example 2 | Diisopropyl ether | 2.52 | 21.800 | 0.273 | 0.424 |
| Example 3 | Dipropyl ether | 1.93 | 22.150 | 0.218 | 0.400 |
| Example 4 | Chlorobenzene | 2.70 | 22.810 | 0.272 | 0.435 |
| Example 5 | Methoxybenzene | 3.18 | 22.670 | 0.285 | 0.492 |
| Example 6 | 4-Methoxytoluene | 3.14 | 23.270 | 0.279 | 0.484 |

**[Table 2]**

| | Poor solvent | η (%) | Jsc (mA/cm²) | Voc (V) | FF (-) |
|---|---|---|---|---|---|
| Reference Example 1 | Tetrahydrofuran | 0.00 | 0.000 | 0.000 | 0.000 |
| Reference Example 2 | Diisopropyl ether | 2.90 | 22.730 | 0.274 | 0.466 |
| Reference Example 3 | Dipropyl ether | 2.39 | 21.820 | 0.242 | 0.454 |
| Reference Example 4 | Methoxybenzene | 2.85 | 24.130 | 0.247 | 0.478 |
| Reference Example 5 | 4-Methoxytoluene | 3.28 | 24.180 | 0.265 | 0.511 |
| Reference Example 6 | Toluene | 3.04 | 23.190 | 0.270 | 0.480 |

**[Table 3]**

| | Solution concentration (mol/L) | η (%) | Jsc (mA/cm²) | Voc (V) | FF (-) |
|---|---|---|---|---|---|
| Reference Example 7 | 0.9 | 0.69 | 19.080 | 0.121 | 0.297 |
| Reference Example 8 | 1.5 | 0.00 | 6.464 | 0.011 | 0.00 |

### (Discussion)

The photoelectric conversion elements of Examples 1 to 6 have IV characteristics equivalent or superior to the photoelectric conversion elements of Reference Examples 1 to 6, which were formed by a conventional technique (i.e., a technique involving dropwise addition of a poor solvent). The photoelectric conversion elements of Reference Examples 7 and 8, which were formed entirely without using a poor solvent, have significantly lower characteristics than the photoelectric conversion elements of Examples 1 to 6 and Reference Examples 1 to 6, as demonstrated by FIG. 4 and Table 3.

In the examples, the photoelectric conversion elements were each successfully formed in a simple manner because dropwise addition of a poor solvent was not performed during the spin coating of the precursor solution of the photoelectric conversion layer. Furthermore, in the examples, the amount of poor solvent used was successfully reduced to about one-eighteenth of that used in the conventional technique. Moreover, in Reference Examples 7 and 8 where no poor solvent was used at all, the elements each exhibit significantly degraded characteristics. The above demonstrates that poor solvents significantly affect the performance of the resulting photoelectric conversion elements, specifically the performance of the resulting photoelectric conversion layers, and further demonstrates that dropwise addition of such poor solvents, which affect performance in this manner, is prone to cause characteristic variations. The examples presumably succeeded in forming homogeneous films by not undergoing the operation of poor solvent dropwise addition, which is prone to cause variations within the resulting films (the photoelectric conversion layers in the present examples).

As is evident from the comparison of Example 1 with Reference Example 1, when tetrahydrofuran was used as the poor solvent, the photoelectric conversion element formed by the conventional technique did not exhibit photoelectric conversion characteristics, whereas the photoelectric conversion element formed by the technique of the present invention exhibited excellent IV characteristics.

### INDUSTRIAL APPLICABILITY

The photoelectric conversion element of the present disclosure can be included, for example, in solar cells.

## Claims

1. A composition comprising a perovskite compound precursor, a first solvent, and a second solvent, wherein
the first solvent has a boiling point of 50°C or more and a dipole moment of 3.0 D or less, and does not dissolve a perovskite compound formed from the perovskite compound precursor, and
the second solvent has a dipole moment of more than 3.0 D, and dissolves the perovskite compound.

2. The composition according to claim 1, wherein
the first solvent has a dipole moment of 1.78 D or less.

3. The composition according to claim 1 or 2, wherein
the first solvent has a boiling point of 100°C or more.

4. The composition according to any one of claims 1 to 3, wherein
the first solvent includes a compound having a benzene ring.

5. The composition according to claim 1 or 2, wherein
the first solvent includes at least one selected from the group consisting of tetrahydrofuran, dipropyl ether, diisopropyl ether, toluene, chlorobenzene, methoxybenzene, and methoxytoluene.

6. The composition according to any one of claims 1 to 5, wherein
the perovskite compound precursor includes a monovalent cation, a divalent cation, and a monovalent anion.

7. The composition according to claim 6, wherein
the monovalent cation includes an inorganic cation.

8. The composition according to claim 6 or 7, wherein
the divalent cation includes at least one selected from the group consisting of a Pb cation and a Sn cation.

9. The composition according to any one of claims 1 to 8, wherein
the second solvent includes at least one selected from the group consisting of dimethyl sulfoxide, N,N-dimethylformamide, gamma-butyrolactone, and N-methyl-2-pyrrolidone.

10. The composition according to any one of claims 1 to 9, wherein
a volume ratio of the second solvent to a sum of the first solvent and the second solvent is 80% or more and 97% or less.

11. The composition according to claim 10, wherein
the volume ratio is 85% or more and 93% or less.

12. The composition according to any one of claims 1 to 11, further comprising an ammonium salt.

13. The composition according to claim 12, wherein
the ammonium salt includes a quaternary ammonium salt.

14. The composition according to claim 12 or 13, wherein
the ammonium salt includes at least one selected from the group consisting of tetrabutylammonium iodide and tetrabutylammonium fluoride.

15. The composition according to any one of claims 1 to 14, further comprising a compound including: the same element as a divalent cation included in the perovskite compound precursor; and F.

16. A method for producing a photoelectric conversion layer, the method comprising forming a photoelectric conversion layer by using the composition according to any one of claims 1 to 15.

17. The method according to claim 16, wherein
the photoelectric conversion layer is formed by spin-coating the composition.
